Europäisches Patentamt

European Patent Office

Office européen des brevets

(11) Publication number: **0 251 722**
**A2**

## EUROPEAN PATENT APPLICATION

(21) Application number: **87305692.3**

(22) Date of filing: **25.06.87**

(51) Int. Cl.4: **H 03 H 17/04**
**G 11 B 20/02**

(30) Priority: **26.06.86 JP 151159/86**

(43) Date of publication of application:
**07.01.88 Bulletin 88/01**

(84) Designated Contracting States: **DE FR GB NL**

(71) Applicant: **Pioneer Electronic Corporation**
**4-1 Meguro 1-chome**
**Meguro-ku Tokyo 153 (JP)**

(72) Inventor: **Ueda, Hitoshi c/o Pioneer Electronic Corp.**
**Tokorozawa Works No. 2610, Hanazono 4-chome**
**Tokorozawa-shi Saitama (JP)**

(74) Representative: **Brunner, Michael John et al**
**GILL JENNINGS & EVERY 53-64 Chancery Lane**
**London WC2A 1HN (GB)**

(54) Digital filter for time-axis error correction loop of video disk player.

(57) A digital filter unit, such as may be used in a time-axis error correction loop of a video disk player or the like, having a simplified construction and reduced servo lag time. The inventive filter unit includes an analog-to-digital converter for converting a signal representing a phase difference between a reference horizontal synchronizing signal and an a horizontal synchronizing signal extracted from the reproduced video signal, a digital filter unit to which the phase-difference signal is applied, a digital-to-analog converter for converting the digital output from the digital filter back into an analog signal, and an analog low-pass filter which smooths the analog output from the digital-to-analog converter. In accordance with the inventive concept, in the output signal from the digital-to-analog converter, the frequency response characteristic in a relatively high frequency band is determined by the digital filter, while the characteristic in a relatively low frequency band is determined by the analog low-pass filter.

*FIG. 3*

**Description**

## DIGITAL FILTER FOR TIME-AXIS ERROR CORRECTION LOOP OF VIDEO DISK PLAYER

### BACKGROUND OF THE INVENTION

The present invention relates to a digital filter unit appropriate for use as an equalizer for compensating the time-axis error correction loop of a video disk player.

In a digital filter unit of the same general type as the present invention, the frequency response characteristic in a relatively high frequency band is determined by a digital filter, and the frequency response characteristic in a relatively low frequency band is determined by a smoothing analog low-pass filter.

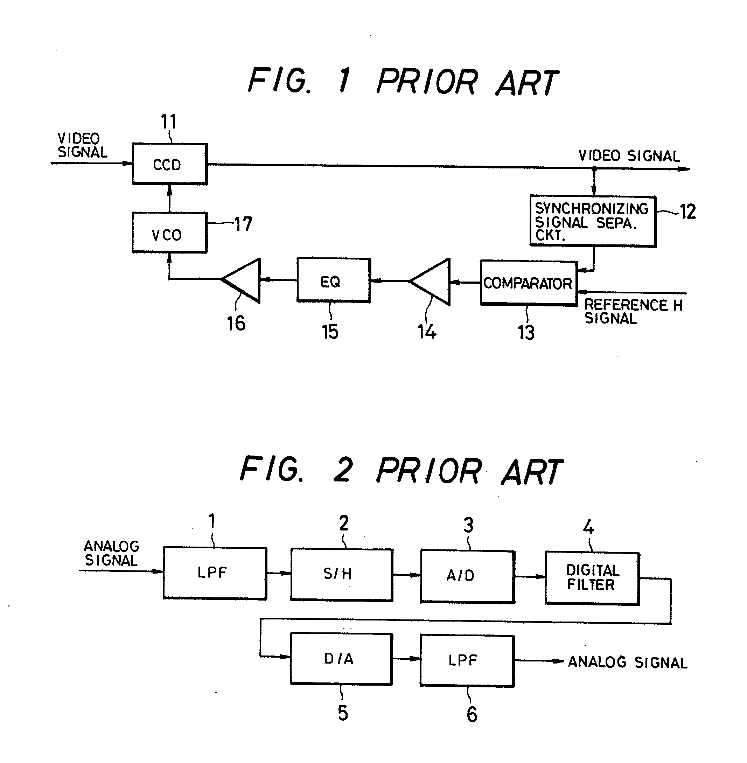

As shown in Fig. 1, a video disk player is provided with such a time-axis error correction loop to correct the time-axis error of the reproduced video signal. Indicated at 11 in Fig. 1 is a charge-coupled delay circuit used to delay an input video signal by a prescribed time period. The video signal outputted from the charge-coupled device 11 is applied to a synchronizing signal separation circuit 12 where a horizontal synchronizing signal is extracted. The reproduced horizontal synchronizing signal is passed to a comparison circuit 13 where the signal is compared with a reference horizontal synchronizing signal. The comparison circuit 13 thus produces a signal which corresponds to the phase difference between the compared horizontal synchronizing signals. This phase difference indicating signal is applied to a voltage-controlled oscillator circuit 17 through an amplification circuit 14, an equalizer 15, and an amplifiction circuit 16. A clock signal, produced by the oscillation circuit 17 and which drives the charged-coupled device 11, has a frequency which changes depending on the amount of time-axis error of the horizontal synchronizing signal (video signal) in such a manner that the time-axis error of the video signal is corrected through the delaying action of the charge-coupled device 11.

To implement digitally the equalizer 15 of the time-axis error correction loop, a digital filter unit such as shown in Fig. 2 can be used. Indicated at 1 in Fig. 2 is an analog low-pass filter which limits the frequency band of the input analog signal to eliminate holding noise caused by sampling. The analog output of the analog low-pass filter 1 is sampled-and-held at a prescribed sampling frequency by a sample-and-hold circuit 2, and then converted to a digital signal by an A/D converter circuit 3. The digital signal is passed through a digital filter 4 where the signal is provided with a desired characteristic through operations such as multiplication and addition in accordance with a predetermined filtering equation. The digital signal produced by the digital filter 4 is converted into an analog signal by a D/A converter circuit 5. The analog signal is smoothed (interpolated) by an analog low-pass filter 6.

The output signal from the D/A converter circuit 5 changes at the rate of the sampling frequency. That is, the signal is a pulse-amplitude modulation wave. The cutoff frequency of the low-pass filter 6 is set at half the sampling frequency, resulting in attenuation of 60 to 70 dB in the frequency band above the cutoff frequency.

To achieve the desired frequency response characteristic with the digital filter 4, it is necessary to employ a complex circuit construction. Also, the quantization error due to the finite word length makes it difficult to attain the desired characteristic at all with the digital filter. It also makes it difficult to design the low-pass filter connected to the output of the D/A converter circuit. Moreover, the digital filtering process is time-consuming, resulting in a deterioration in the desired characteristics of the overall servo system.

### SUMMARY OF THE INVENTION

The digital filter unit provided in accordance with the present invention comprises an A/D converter circuit which converts an analog signal into a digital signal, a digital filter which operates on the digital signal received from the A/D converter circuit to impart to the digital signal a prescribed characteristic, a D/A converter circuit which converts the digital signal received from the digital filter into an analog signal, and an analog low-pass filter which smooths the analog signal from the D/A converter circuit. The characteristic of the output signal in a relatively high frequency band is determined by the digital filter, while the characteristic in a relatively low frequency band is determined by the analog low-pass filter.

### BRIEF DESCRIPTION OF THE DRAWINGS

Fig. 1 is a block diagram of a time-axis error corrector in an analog system;

Fig. 2 is a block diagram of a conventional digital filter unit;

Fig. 3 is a block diagram illustrating an application of a digital filter unit of the present invention in a time-axis error corrector;

Figs. 4 and 5 show characteristics of a digital filter unit of a preferred embodiment of the present invention; and

Figs. 6 and 7 are signal flow charts of the digital filter unit of the preferred embodiment of the present invention.

### DESCRIPTION OF THE PREFERRED EMBODIMENT

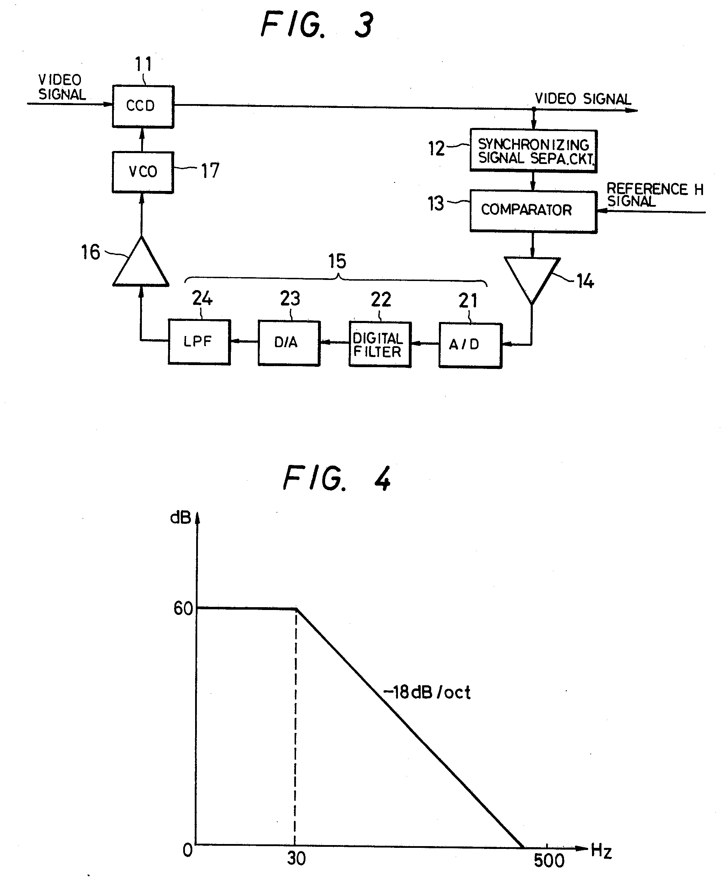

Fig. 3 is a block diagram of a time-axis error corrector in which a digital filter unit constructed in accordance with a preferred embodiment of the present invention is used to advantage. The mutually corresponding portions in Figs. 1 and 3 are indicated by the same reference numerals, and are not described in further detail hereinafter.

The digital filter unit is an equalizer 15 including an A/D converter circuit 21 which converts an input analog signal into a digital signal, a digital filter 22 which operates on the digital signal received from the A/D converter circuit 21 to provide it with a desired characteristic, a D/A converter circuit 23 which converts the digital signal received from the digital filter into an analog signal, and an analog low-pass filter 24 which smooths the analog signal from the D/A converter circuit 23.

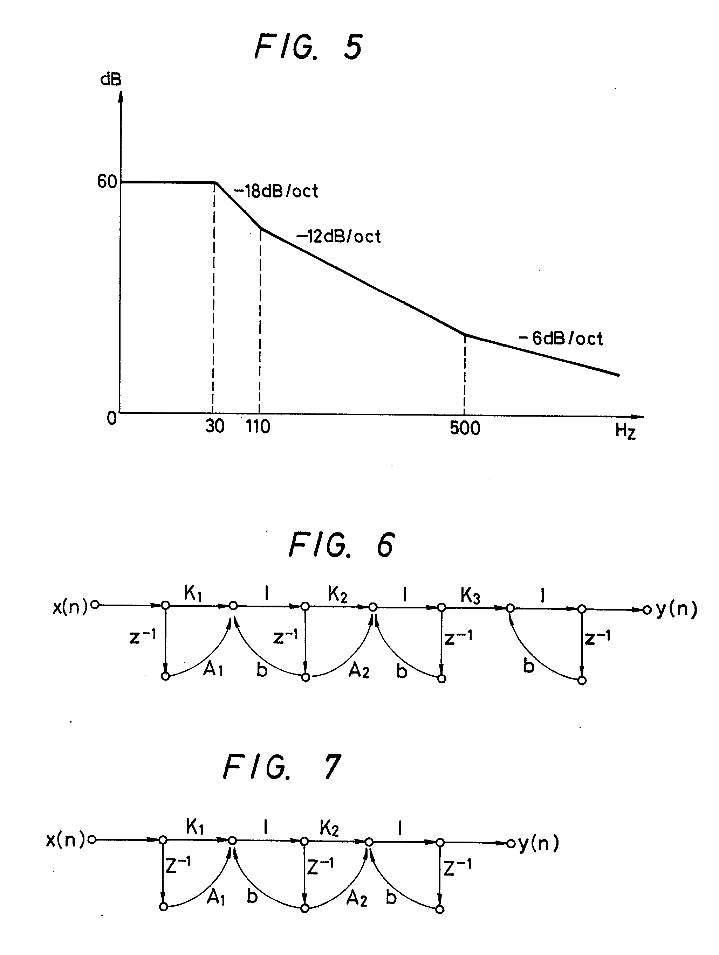

The characteristic that the equalizer 15 (digital filter 22) is required to provide is determined in accordance with the applicable standard for time-axis error of a video disk, as shown in Fig. 4. To achieve this characteristic, the transfer function of the digital filter 22 is determined so as to provide a triple point at 30 Hz and zero points at 110 Hz and 500 Hz, as shown in Fig. 5.

The transfer function is expressed by:
$$G_1(s) = G_0(s+2\pi\bullet110)(s+2\pi\bullet500)/(s+2\pi\bullet30)^3 \quad ...(1)$$
The symbol $G_0$ denotes a gain constant.

Applying to equation (1) a mapping method for mapping an analog transfer function represented by a Laplace transform to a digital transfer function represented by a Z transform, for example, a matched Z transform, the following equation is obtained:
$$G_2(Z^{-1}) = G_3(1-\exp(-110\bullet2\pi\bullet T)Z^{-1})(1-\exp(500\bullet2\pi\bullet T)Z^{-1}/(1-\exp(-30\bullet2\pi\bullet T)Z^{-1})^3, \quad ...(2)$$
where $G_3$ is a constant.

For a sampling time T of 63.5 μs, equation (2) is transformed into ($G_3 = 0.21707\text{x}10^{-3}$):
$$G_2(Z^{-1}) = G_3(1-0.95707Z^{-1})(1-0.81917Z^{-1})/(1-0.98810Z^{-1})^3 \quad ...(3)$$

Equation (3) can be rewritten, with the condition that the digital filter 22 is constructed by cascade connection, as:
$$G_2(Z^{-1}) = \{K_1(1+a_1Z^{-1})/(1-bZ^{-1})\}\{K_2(1+a_2Z^{-1})/(1-bZ^{-1})\}\{K_3/(1-bZ^{-1})\} \quad ...(4)$$

The constants in equation (4) are as follows:
$a_1 = -0.95707$
$a_2 = -0.81917$
$b = 0.98810$
$K_1 = (1-b)/(1+a_1)$
$= (1-0.98810)/(1-0.95707)$
$= 0.27720$
$K_2 = (1-b)/(1+a_2)$
$= (1-0.98810)/(1-0.81917)$
$= 0.065808$
$K_3 = 1-b$
$= 0.01190$

Equation (4) can then be rewritten as:
$$G_2(Z^{-1}) = \{(K_1+A_1Z^{-1})/(1-bZ^{-1})\}\{(K_2+A_2Z^{-1})/(1-bZ^{-1})\}\{K_3/(1-bZ^{-1})\} \quad ...(5)$$

The constants in equation (5) are as follows:
$A_1 = K_1a_1 = -0.26530$
$A_2 = K_2a_2 = -0.053908$

Fig. 6 is a signal flow chart indicative of the implementation of the equation (5). It is difficult to provide the desired characteristic with a finite word length such as 12 bits. For that reason, according to the present invention, the analog low-pass filter 24 is employed to provide a part of the desired overall characteristic of the equalizer 15 (digital filter 22).

For this purpose, equation (1) is rewritten as:
$$G_1(s) = G_0\{(s+2\pi\bullet110)/(s+2\pi\bullet30)\}\{(s+2\pi\bullet500)/(s+2\pi\bullet30)\}\{1/(s+2\pi\bullet30)\} \quad ...(6)$$

Equation (6) can be regarded as meaning that three analog low-pass filters are cascaded together. Since the cutoff frequency of the analog low-pass filter corresponding to the last term $1/(s+2\pi\bullet30)$ is 30 Hz, the filter can be replaced by the smoothing analog low-pass filter 24 having a 75 kHz cutoff frequency. Consequently, the portion of the transfer function that should be provided by the digital filter 22 is expressed as follows:
$$G_4(s) = \{G_3(s+2\pi\bullet110)/(s+2\pi\bullet30)\}\{(s+2\pi\bullet500)/(s+2\pi\bullet30)\} \quad ...(7)$$

Subjecting equation (7) to a matched z transform results in:
$$G_4(Z^{-1}) = \{(1-\exp(-110\bullet2\pi\bullet T)Z^{-1})/(1-\exp(-30\bullet2\pi\bullet T)Z^{-1})\}$$
$$\{(1-\exp(-500\bullet2\pi\bullet T)Z^{-1})/(1-\exp(-30\bullet2\pi\bullet Z^{-1})\}$$
$$= \{(1-0.95707Z^{-1})/(1-0.98810Z^{-1})\}\{(1-0.81917Z^{-1})/(1-0.98810Z^{-1})\} \quad ...(8)$$

Equation (8) can be transformed in consideration of the cascade connection as:
$$G_4(Z^{-1}) = \{K_1(1+a_1Z^{-1})/(1-bZ^{-1})\}\{K_2(1+a_2Z^{-1})/(1-bZZ^{-1})\} \quad ...(9)$$

Equation (9) is then rewritten as:
$$G_4(Z^{-1}) = \{(K_1+A_1Z^{-1})/(1-bZ^{-1})\}\{(K_2+A_2Z^{-1})/(-1-bZ^{-1})\} \quad ...(10)$$

Fig. 7 is a signal flow chart indicative of the constitution of equation (10). The number of times of multiplication and addition in the case shown in Fig. 7 is less than in the case of Fig. 5. For that reason, not only is the quantization error due to finite word length reduced, but also the total computation time is shortened, resulting in a reduced servo lag time, and hence preventing a deterioration of the desired characteristic of the overall servo system.

Although the above-described embodiment is applied to a time-axis error correction loop, the present invention is not confined thereto.

As described above, a digital filter unit provided in accordance with the present invention includes an A/D converter circuit which converts an input analog signal into a digital signal, a digital filter which operates on the digital signal received from the A/D converter circuit to provide it with a prescribed characteristic, a D/A converter circuit which converts the digital signal from the digital filter into an analog signal, and an analog low-pass filter which smooths the analog signal from the D/A converter circuit. The characteristic of the final output signal in a relatively high frequency band is determined by the digital filter, while the characteristic in a relatively low frequency band is determined by the analog low-pass filter. As a result, a desired overall characteristic is attained while reducing the total number of circuit elements needed and reducing the lag time through the circuit.

## Claims

1. A digital filter unit comprising: digital filter means for operating on an input digital signal to provide said digital signal with a prescribed characteristic; D/A converter means for converting a digital output signal from said digital filter into an analog signal; and analog low-pass filtering means for smoothing an analog output signal from said D/A converter circuit; a characteristic in a relatively high frequency band being determined by said digital filter, and a characteristic in a relatively low frequency band being determined by said analog low-pass filter.

2. The digital filter unit of claim 1, wherein said characteristic in a relatively high frequency band has the form of:
$$G_4(Z^{-1}) = \{(K_1 + A_1 Z^{-1})/(1-bZ^{-1})\}\{(K_2 + A_2 Z^{-1})/(1-bZ^{-1})\},$$ wherein $K_1$, $A_1$, $b$, $K_2$ and $A_2$ are constants.

3. A time-axis error correction loop for video disk player, comprising: a charge-coupled device delay line receiving as an input a video signal; a synchronizing signal separating circuit for separating from a signal at an output of said charge-coupled device delay line a horizontal synchronizing signal; a phase comparator for comparing in phase a reference horizontal synchronizing signal with the horizontal synchronizing signal separated by said synchronizing signal separating circuit; an analog-to-digital converter receiving as an input and output of said phase comparator; a digital filter receiving as an input a digital output from said analog-to-digital converter; a digital-to-analog converter receiving as an input an output of said digital filter; a low-pass filter receiving as an input an analog output of said digital-to-analog converter; a voltage-controlled oscillator receiving as a control voltage an output from said low-pass filter, an output of said voltage-controlled oscillator being applied as a clock input to said charge-coupled device delay line, wherein said digital filter comprises: digital filter means for operating on an input digital signal to provide said digital signal with a prescribed characteristic; D/A converter circuit means for converting a digital output signal from said digital filter into an analog signal; and analog low-pass filtering means for smoothing an analog output signal from said D/A converter circuit; a characteristic in a relatively high frequency band being determined by said digital filter, and a characteristic in a relatively low frequency band being determined by said analog low-pass filter.

4. The digital filter unit of claim 1, wherein said characteristic in a relatively high frequency band has the form of:
$$G_4(Z^{-1}) = \{(K_1 + A_1 Z^{-1})/(1-bZ^{-1})\}\{(K_2 + A_2 Z^{-1})/(1-bZ^{-1})\},$$
wherein $K_1$, $A_1$, $b$, $K_2$ and $A_2$ are constants.

0251722

# FIG. 1 PRIOR ART

VIDEO SIGNAL → CCD (11) → VIDEO SIGNAL

VCO (17)

SYNCHRONIZING SIGNAL SEPA. CKT. (12)

(16) ← EQ (15) ← (14) ← COMPARATOR (13) ← REFERENCE H SIGNAL

# FIG. 2 PRIOR ART

ANALOG SIGNAL → LPF (1) → S/H (2) → A/D (3) → DIGITAL FILTER (4)

→ D/A (5) → LPF (6) → ANALOG SIGNAL

## FIG. 3

## FIG. 4

## FIG. 5

dB

60

−18dB/oct

−12dB/oct

−6dB/oct

0          30  110                    500          Hz

## FIG. 6

$x(n)$ ○ —→ $K_1$ —→ I —→ $K_2$ —→ I —→ $K_3$ —→ I —→ ○ $y(n)$

$z^{-1}$        $z^{-1}$        $z^{-1}$        $z^{-1}$

$A_1$   b      $A_2$   b      b

## FIG. 7

$x(n)$ ○ —→ $K_1$ —→ I —→ $K_2$ —→ I —→ ○ $y(n)$

$z^{-1}$        $z^{-1}$        $z^{-1}$

$A_1$   b      $A_2$   b